**Europäisches Patentamt**

**European Patent Office**

**Office européen des brevets**

(19)

(11) Veröffentlichungsnummer : **0 320 642 B1**

(12)
# EUROPÄISCHE PATENTSCHRIFT

(45) Veröffentlichungstag der Patentschrift :
**05.10.94 Patentblatt 94/40**

(51) Int. Cl.$^5$ : **H03M 1/10, H03M 1/38**

(21) Anmeldenummer : **88119236.3**

(22) Anmeldetag : **18.11.88**

(54) **Kalibrierungsverfahren für redundante A/D-und D/A-Umsetzer mit gewichtetem Netzwerk.**

(30) Priorität : **14.12.87 DE 3742361**

(43) Veröffentlichungstag der Anmeldung :
**21.06.89 Patentblatt 89/25**

(45) Bekanntmachung des Hinweises auf die
Patenterteilung :
**05.10.94 Patentblatt 94/40**

(84) Benannte Vertragsstaaten :
**AT BE CH DE FR GB IT LI LU NL SE**

(56) Entgegenhaltungen :
**GB-A- 2 022 347**
**US-A- 4 336 526**

(56) Entgegenhaltungen :
**IEEE INTERNATIONAL SOLID-STATE CIR-
CUITS CONFERENCE, Band 27, 22.-24. Fe-
bruar1984, San Fransisco, Conference 31,
Seiten 64-65,319, IEEE, New York, US; H.-
S.LEE et al.: "A self-calibrating 12b 12mus
CMOS ADC"**
**IEEE TRANSACTIONS ON CIRCUITS AND SY-
STEMS, Band CAS-30, Nr. 3, März 1983, Seiten
188-190; H.-S. LEE et al.: "Self-calibration
technique for A/D converters"**

(73) Patentinhaber : **SIEMENS
AKTIENGESELLSCHAFT
Wittelsbacherplatz 2
D-80333 München (DE)**

(72) Erfinder : **Draxelmayr, Dieter, Dipl.-Ing.
Tschinowitscher Weg 46
A-9500 Villach (AT)**

EP 0 320 642 B1

Anmerkung : Innerhalb von neun Monaten nach der Bekanntmachung des Hinweises auf die Erteilung des europäischen Patents kann jedermann beim Europäischen Patentamt gegen das erteilte europä- ische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patent- übereinkommen).

## Beschreibung

Die Erfindung betrifft ein Kalibrierungsverfahren für redundante A/D- und D/A-Umsetzer mit gewichtetem Netzwerk und Fehlerkorrektur.

Die wichtigste und kritischte Schnittstelle zwischen verschiedenen Typen von Systemen ist gewöhnlich die Verbindung zwischen analogen und digitalen Teilen der Systeme. Die Schnittstelle zwischen einem digitalen Kreis und einem analogen Kreis benötigt dabei einen D/A-Umsetzer, während die Schnittstelle zwischen einem analogen Kreis und einem digitalen Kreis entsprechend einem A/D-Umsetzer erfordert. Ein natürlich real nicht existierender idealer Umsetzer setzt ein digitales bzw. analoges Signal ohne Verzögerung und ohne Fehler in ein analoges bzw. digitales Signal um. Es sind vielfältige Umsetzverfahren bekannt, von denen eine Reihe in der Veröffentlichung von Bernard Gordon, "Linear Electronic Analog/Digital Conversion Architectures, Their Origin, Parameters, Limitations and Applications", IEEE Transactions of Circuits and Systems, CAS-25, July 1978, beschrieben sind. Unter derselben Fundstelle ist eine Veröffentlichung von P.R. Grey und D.G. Hodges "All MOS Analog/Digital Conversion Techniques" erschienen.

Bei vielen Typen von A/D- und D/A-Umsetzern benötigt man Referenzelemente, die aus einer vorgegebenen Referenzgröße weitere Größen ableiten, die für eine Umsetzung benötigt werden. Diese Referenzelemente bilden ein gewichtetes Netzwerk und werden nachfolgend als gewichtete Elemente bezeichnet. In der Praxis werden die gewichteten Netzwerke meistens durch Widerstände, Kondensatoren oder Transistoren realisiert. Derartige Umsetzer arbeiten beispielsweise nach den Verfahren der sukzessiven Aproximation, für die als ein Vertreter ein Umsetzer mit Ladungsverteilung (Charge Redistribution) gelten kann, bei dem das gewichtete Netzwerk aus Kapazitäten besteht. Gewichtete Widerstandsnetzwerke sind beispielsweise in Umsetzern nach dem Verfahren der gewichteten Ströme oder mit einem Leiternetzwerk (R-2R) bekannt.

Bei Umsetzern mit gewichtetem Netzwerk ist es wichtig, daß die gewichteten Elemente zueinander in einem genau vorgegebenen Verhältnis stehen. Für hochgenaue Umsetzer müssen die gewichteten Elemente hochgenau sein. Probleme ergeben sich jedoch, weil die gewichteten Elemente nicht genau genug hergestellt werden können. Üblicherweise erfolgt deshalb eine Korrektur, für die verschiedene Verfahren möglich sind, die jedoch Nachteile aufweisen. So sind lasergetrimmte Widerstandsnetzwerke bezüglich des Fabrikationsprozesses und der Chipfläche kostspielig und unterliegen zeitabhängig der Drift. Eine weitere Möglichkeit zur Korrektur besteht in der Verwendung eines Korrektur-PROMs, in das Korrekturwerte wie bei Trimmverfahren nach der Fertigung des Bausteins eingebracht werden, wie es beispielsweise von der Fa. Intersil im Baustein ICL 7115 realisiert ist.

Eine weitere Möglichkeit zur Kalibrierung von A/D- bzw. D/A-Umsetzern besteht in der Möglichkeit der Selbstkalibrierung und ist beispielsweise aus der US-PS 4,451,821 (Domogalla) und der Veröffentlichung von H.S. Lee und D.A. Hodges "Self-Calibration Technique for A/D Converters", IEEE Transactions on Circuits and Systems, Vol. CAS-30, No. 3, March 1983 bekannt. Die beschriebenen Verfahren der sukzessiven Approximation setzen ein binär gewichtetes Netzwerk voraus, bei dem das kleinste Element doppelt vorhanden ist. Dann ist im Idealfall ein gewichtetes Element identisch gleich der Summe aller niedriger gewichteten Elemente (Bits). Bei dieser Selbstkalibrierung wird schrittweise für jedes gewichtete Element des Netzwerks die Gewichtungsabweichung von der Gewichtungssumme aller jeweils niedriger gewichteten Elemente festgestellt. Aus dieser Differenz, die idealerweise Null ist, kann offensichtlich der jedem gewichteten Element zuzuordnende Gewichtungsfehler bestimmt werden, der abgespeichert wird und dann über einen Umsetzvorgang zur Korrektur des Ergebnisses benutzt werden kann. Dieser Gewichtungsfehler wird üblicherweise mit Hilfe eines Korrektur-Gewichtungssatzes, beispielsweise einem Kalibrierungs-D/A-Umsetzer oder einem speziellen Netzwerk, ermittelt und abgespeichert. Zur Zuordnung der Korrektur-Gewichtungen zu den einzelnen gewichteten Elementen ist eine Recheneinheit, beispielsweise ein Mikrocomputer, erforderlich. Ein Nachteil dieser bekannten Verfahren besteht darin, daß aufgrund des Prinzips der Korrektur der gewichteten Elemente bezüglich des jeweiligen Idealwerts und aufgrund der vorgesehenen Kalibrierungsschritte nur binär gewichtete Netzwerke verwendet werden können.

Zur Erhöhung der Geschwindigkeit und der Auflösung von A/D- bzw. D/A-Umsetzern ist weiterhin ein Fehlerkorrekturverfahren mit Hilfe eines redundanten Umsetzers aus der Veröffentlichung von Z.G. Boyacigiller "An Error Correcting 14b/20 μs CMOS A/D Converter", ISSCC 81, Seite 62 f bekannt. Ein derartiger auch als Codeüberlappungsumsetzer bezeichneter redundanter A/D bzw. D/A-Umsetzer arbeitet mit einem gewichteten Netzwerk und beim beschriebenen Verfahren nach der sukzessiven Approximation. Bei diesen Wandlern ist das Verhältnis der gewichteten Elemente zwischen einem gewichteten Element und dem nächsten niedriger gewichteten Element eine Konstante kleiner als 2. In der genannten Veröffentlichung ist das Verhältnis 1,85. Damit ergibt sich eine Redundanz in der Codierung, und mit Hilfe des vorgestellten Fehlerkorrektur-Algorithmus können Fehler bei der Umsetzung hochgewichteter Bits, die durch die unzureichende Einschwingdauer (Settling Time) des Komparators hervorgerufen werden, mit Hilfe niedrigwertiger Bits korrigiert werden.

Zur Kalibrierung des Wandlers wird jeder Bitwert mit Hilfe des internen Komparators und einer exakt kalibrierten Eingangsspannung gemessen und abgespeichert. Bei einer späteren Umsetzung werden dann die aus dem Speicher entnommenen Bits in einem Rechner aufaddiert, und das Ergebnis liegt im fehlerkorrigierten Binärcode vor, wobei allerdings die Bitbreite des Binärcodes des gegenüber der Bitbreite des Redundanzcodes entsprechend geringer ist. Ein Selbstkalibrierungsverfahren für redundante Wandler ist bisher nicht bekannt.

Aus US-A-4,336,526 ist ein redundanter A/D-Wandler bekannt, bei dem die Wichtungsfaktoren der einzelnen gewichteten Elemente bei der Herstellung gemessen und abgespeichert werden. Eine Selbstkalibrierung des Wandlers ist nicht vorgesehen.

Der Erfindung liegt die Aufgabe zugrunde, ein Kalibrierungsverfahren für redundante A/D- und D/A-Umsetzer anzugeben, mit dem sich die Umsetzgeschwindigkeit, das Auflösungsvermögen und die Genauigkeit der Wandler weiter verbessern läßt.

Diese Aufgabe wird erfindungsgemäß durch die Merkmale der Patentansprüche 1 oder 2 gelöst.

Der Erfindung liegt der Gedanke zugrunde, für einen redundanten Umsetzer mit gewichtetem Netzwerk eine Selbstkalibrierung dadurch vorzusehen, daß die gewichteten Elemente mit ihrer Gewichtung bestimmt werden und daß diese gewonnenen Werte zur A/D- bzw. D/A-Umsetzung unter Zuhilfenahme eines an sich bekannten Fehlerkorrekturverfahrens herangezogen werden.

Ausgestaltungen der Erfindung sind in abhängigen Ansprüchen gekennzeichnet.

Die Erfindung wird im folgenden anhand eines A/D-Umsetzers nach dem Verfahren der sukzessiven Approximation mit gewichtetem Kapazitätsnetzwerk näher erläutert. Derartige gewichtete Netzwerke sind auch aus den vorgenannten Veröffentlichungen von Lee et al, Boyacigiller et al und Domogalla bekannt. Es muß jedoch betont werden, daß die Erfindung keineswegs auf Umsetzer mit kapazitivem Netzwerk und auf Umsetzer beschränkt ist, die nach dem Verfahren der sukzessiven Approximation arbeiten. Vielmehr läßt sich der Gegenstand der Erfindung genauso vorteilhaft für nach anderem Prinzip arbeitende Umsetzer einsetzen.

Die Erläuterung der Erfindung erfolgt anhand der in den Figuren dargestellten Ausführungsbeispiele eines A/D-Umsetzers. Figur 1 zeigt ein nicht beanspruchtes Beispiel eines Kalibrierungsverfahrens. In Figuren 2 und 3 sind zwei bevorzugte Ausgestaltungen des erfindungsgemäßen Verfahrens dargestellt. Gleiche Elemente sind mit gleichen Bezugszeichen versehen. Die Grundelemente zur Durchführung des erfindungsgemäßen Verfahrens sind in den Figuren die gleichen.

Der Umsetzer enthält das gewichtete Kapazitätsnetzwerk CN mit den Kapazitäten C0 bis Cn, denen in einem Schalternetzwerk SN Schalter zugeordnet sind. Der Ausgang d.h. der Summationspunkt SP des gewichteten Kapazitätsnetzwerks CN ist an den Eingang eines Komparators K angeschlossen, dem ein sukzessives Approximationsregister SAR nachgeschaltet ist. Die der internen, d. h. redundanten Anzahl n der Bits entsprechenden Ausgänge n des sukzessiven Approximations-registers bilden einerseits den Ausgang OUT des Umsetzers und sind andererseits entsprechend dem Prinzip des Umsetzers auf das Schalternetzwerk SN und je nach Ausführungsbeispiel auf eine Recheneinheit RE oder auf einen D/A-Umsetzer mit Register DAR zurückgeführt. Ein Eingangsmultiplexer MUX mit Eingängen, die durch zwei Referenzspannungen UR1 und UR2 sowie durch den Eingang UI für das umzuwandelnde Analogsignal festgelegt sind, führt ausgangsseitig auf das Schalternetzwerk SN. Eine Zeitkontrolleinheit und eine Kalibrierungslogik zur Durchführung der Kalibrierung TCN steuern sowohl den Multiplexor MUX als auch das Schalternetzwerk SN und stehen über Datenleitungen in Verbindung mit der Recheneinheit RE, die selbstverständlich Speicherelemente enthält.

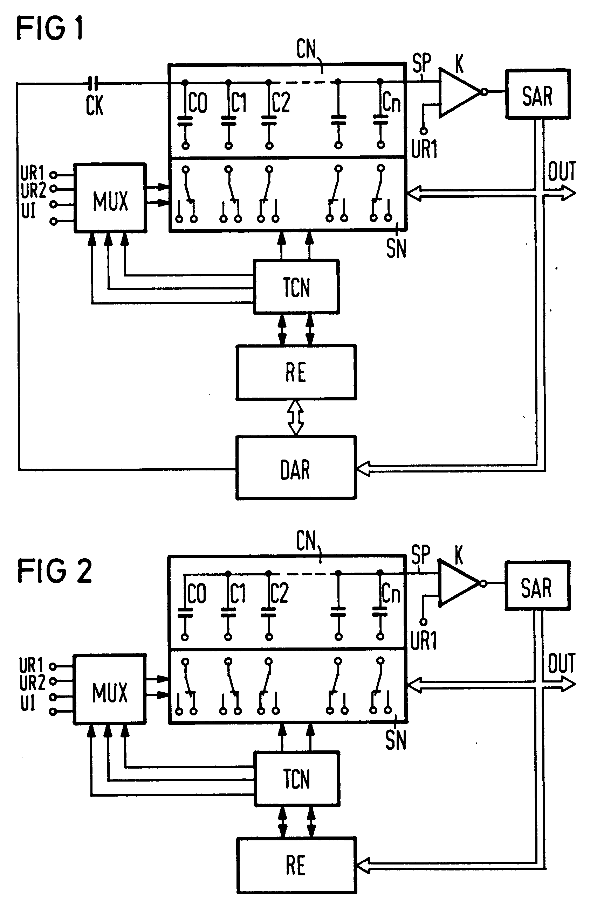

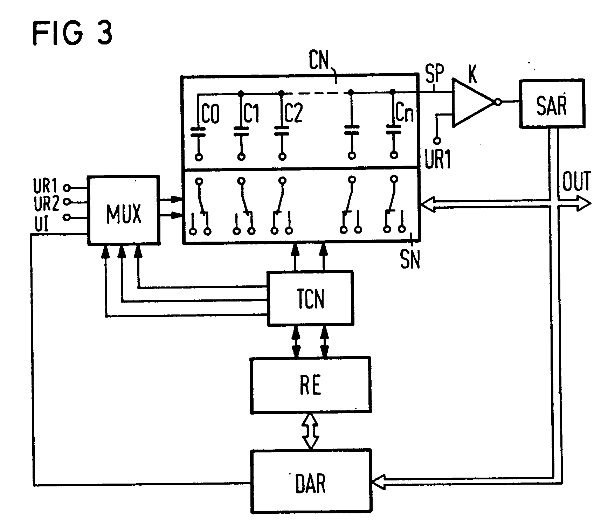

Anhand der in den Figuren 2 und 3 dargestellten Anordnungen werden zwei Ausführungsbeispiele eines erfindungsgemäßen Verfahrens beschrieben, wobei immer vorausgesetzt wird, daß die Summe aller gewichteten Elemente, d.h. die Summe aller Kapazitäten C0 bis Cn, als Bezugsgröße bzw. als Einheitswert herangezogen wird. Das erfindungsgemäße Kalibrierungsverfahren beruht darauf, daß in n-Schritten bis auf das niedrigste Elemente jedes der gewichteten Elemente bezüglich der jeweils niedriger gewichteten Elemente bzw. entsprechend jedes Bit bezüglich der jeweils niedrigeren Bits dargestellt wird. Es entsteht damit ein Gleichungssystem, das es ermöglicht, jedes einzelne gewichtete Element bzw. Bit bezogen auf die Gesamtheit bzw. Summe aller gewichteten Elemente zu berechnen. Damit ist dann entsprechend der Veröffentlichung Boyacigiller eine Errechnung des binären Ausgangscodes möglich.

In der Praxis wird zunächst das niedrigste gewichtete Element zusammen mit Meßtermen als Parameter angesehen und das Gleichungssystem in Abhängigkeit von den Parametern berechnet. Anschließend wird die Summe aller gewichteten Elemente als Normierungswert herangezogen und dann der Wert jedes gewichteten Elements bezüglich des Normierungswertes berechnet und abgespeichert.

Das in Fig. 1 dargestellte Beispiel eines Kalibrierungsverfahrens eignet sich besonders für nahezu binär gewichtete Netzwerke. In diesem Beispiel ist der Ausgang des D/A-Umsetzers mit Register DAR über eine Koppelkapazität CK mit dem Summationspunkt SP des gewichteten Netzwerks CN verbunden. Über Datenleitungen ist ein Datenaustausch mit der Recheneinheit möglich. Den Eingang des DAR bilden die Ausgänge

EP 0 320 642 B1

des sukzessiven Approximationsregisters SAR.

Es gilt, daß eine zu untersuchende Kapazität identisch gleich der Summe aller kleineren Kapazitäten plus einem Fehlerterm ist. Schrittweise wird jede der Kapazitäten C1 bis Cn mit der Summe der niedriger gewichteten Elemente verglichen und der Fehlerterm gemessen. Dieses Verfahren wird mit Hilfe der in der FIG 1 dargestellten Elemente durchgeführt, wobei die Recheneinheit RE die Werte bzw. Parameter jedes Schritts speichert. Dazu wird die zu untersuchende Kapazität, die niedriger gewichteten Kapazitäten und der Fehlerterm festgehalten. Nach Abschluß aller Schritte ergibt sich folgendes Gleichungssystem GS 1:

$$
\begin{aligned}
C1 &= C0 &&+ E1 \\
C2 &= C0 + C1 &&+ E2 \\
C3 &= C0 + C1 + C2 &&+ E3 \\
&\cdots\cdots\cdots\cdots\cdots \\
Cn &= C0 + C1 + C2 \ldots + Cn-1 + En \\
C0 &+ C1 + C2 + C3 + \ldots + Cn = FS
\end{aligned}
\tag{GS 1}
$$

Die letzte Gleichung besagt, daß die Summe aller Kapazitäten gleich dem Einheitswert FS (Full scale) ist. Mit dem beschriebenen Kalibrierungsvorgang sind sämtliche Fehlerterme Ei ermittelt. Mit Hilfe der Recheneinheit RE wird dann das Gleichungssystem GS 1 gelöst und die Kapazitäten Ci werden als Funktion der Fehlerterme Ei dargestellt. Dieses Verfahren führt zunächst auf ähnliche Terme wie bei der vorgenannten Veröffentlichung Lee et al. Im Unterschied zu dem bekannten Verfahren, in dem die Fehlerterme anonym bleiben und in weiterer Folge eine analoge Fehlerkompensation durchgeführt wird, werden beim dargestellten Verfahren die Fehlerterme dermaßen bestimmt, daß eine analoge Kompensation nicht erforderlich ist und der digitale Ausgangscode des A/D-Umsetzers korrigiert wird.

In einer weiteren Ausgestaltung dieses Verfahrens lassen sich auch die Abweichungen der Kapazitäten Ci von einem ihnen zuzuordnenden Idealwert darstellen, wenn dieser vorab bekannt ist. Mit der Bestimmung der Kapazitäten Ci anhand des beschriebenen Selbstkalibrierungsverfahrens ist der Wert jedes der zugeordneten Kapazität entsprechenden Bits bezüglich des Gesamtnetzwerks bekannt. Da das Netzwerk CN jedoch ein redundantes Netzwerk ist, das mit Codeüberlappung arbeitet, ist noch eine Codewandlung vom redundanten Code in den Binärcode erforderlich. Diese Codewandlung erfolgt beispielsweise mit Hilfe des von Boyacigiller beschriebenen Verfahres mit gleichzeitiger Fehlerkorrektur.

Das Ausführungsbeispiel eines erfindungsgemäßen Verfahrens gemäß FIG 2 eignet sich auch für nicht annähernd binär gewichtete Netzwerke, d. h., daß die Codeüberlappung des Netzwerks größer ist. Gemäß FIG 2 wird der Ausgang des sukzessiven Approximationsregisters SAR auf die Recheneinheit RE zurückgeführt. Ein D/A-Umsetzer ist bei diesem Verfahren nicht erforderlich. Gemäß diesem zweiten Ausführungsbeispiel wird jede Kapazität bzw. jedes gewichtete Element als Summe einer Anzahl von niederwertigeren Kapazitäten bzw. gewichteten Elementen dargestellt. Voraussetzung zur Durchführung dieses Ausführungsbeispieles der Erfindung ist jedoch, daß dies auch in der Realität möglich ist. Das bedeutet, daß keine Kapazität bzw. keines der gewichteten Elemente größer sein darf als die Summe aller kleineren Kapazitäten bzw. gewichteten Elemente. In der Praxis bedeutet dies jedoch keine wesentliche Einschränkung, da ein guter Umsetzer in jedem Fall diese Bedingung einhalten muß, um keine Codelücken (missing codes) auftreten zu lassen.

Mit dem erfindungsgemäßen Verfahren nach FIG 2 wird nun, entsprechend dem Beispiel gemäß FIG 1, jede der zu untersuchenden Kapazitäten mit niedriger gewichteten Kapazitäten verglichen, und man erhält das Gleichungssystem GS2:

$$
\begin{aligned}
C1 &= D_{00} \cdot C0 \\
C2 &= D_{10} \cdot C0 + D_{11} \cdot C1 \\
C3 &= D_{20} \cdot C0 + D_{21} \cdot C1 + D_{22} \cdot C2 \\
&\cdots\cdots\cdots \\
Cn &= D_{n-1,0} \cdot C0 + D_{n-1,1} \cdot C1 + \ldots + D_{n-1,n-1} \cdot Cn-1 \\
C0 &+ C1 + C2 + \ldots + Cn = FS
\end{aligned}
\qquad D_{ij} = \begin{cases} 0 \\ 1 \end{cases}
\tag{GS 2}
$$

4

Mit dem erfindungsgemäßen Verfahren der Selbstkalibrierung sind die Koeffizienten Dij, bekannt. Aus dem Gleichungssystem GS 2 lassen sich dann die Werte für die Kapazitäten Ci mit Hilfe der Recheneinheit RE berechnen. Da die Koeffizienten Dij nur die Werte 0 oder 1 annehmen können, ist das Ergebnis der Berechnung auch nur in beschränktem Umfang genau. Da jedoch grundsätzlich bei jedem Selbstkalibrierungsverfahren zumindest eine Quantisierungsungenauigkeit berücksichtigt werden muß, kommt dieser Einschränkung keine allzu große Bedeutung zu. Darüberhinaus lassen sich bei einem redundanten Wandler auch mehr interne Bits vorsehen, als der geforderten Anzahl von Binärbits entspricht.

Beim weiteren Ausführungsbeispiel eines erfindungsgemäßen Verfahrens gemäß FIG 3 wird wiederum jedes gewichtete Element, d.h. jede Kapazität schrittweise mit der Summe aller niederwertigeren Kapazitäten verglichen. Der Ausgang des sukzessiven Approximationsregisters SAR führt in den D/A-Umsetzer mit Register DAR, der über Datenleitungen mit der Recheneinheit RE in Verbindung steht. Der Ausgang von DAR ist an einen weiteren Eingang des Multiplexers MUX gelegt.

Im Gegensatz zum vorgestellten Beispiel gemäß FIG 1 wird in diesem Ausführungsbeispiel kein der Summe der Kapazitäten der niederwertigeren Bits hinzuzuzählender Fehlerterm ermittelt, sondern eine an die Summe der niedriger gewichteten Elemente anzulegende Fehlerspannung. Diese Fehlerspannung ergibt sich als Abweichung von der Einheitsspannung, da die Summe der niederwertigeren Elemente typischerweise ja nicht gleich, sondern größer als das zu bestimmende gewichtete Element ist. Sobald dieser bestimmte Spannungsanteil bekannt ist, der an die Summe der niederwertigeren Elemente anzulegen ist, ist das exakte Verhältnis zwischen diesem zugeordneten Bit und dem Rest des gewichteten Netzwerks bekannt. Diese Untersuchung wird für alle Bits vorgenommen. Nach diesem ersten Schritt der Selbstkalibrierung erhält man folgendes Gleichungssystem GS 3:

$$C1 = (1 - dU1) . C0$$
$$C2 = (1 - dU2) . (C0 + C1) \qquad (GS\ 3)$$
$$C3 = (1 - dU3) . (C0 + C1 + C2)$$
$$............$$
$$Cn = (1 - dUn) . (C0 + C1 + C2 + .... + Cn-1)$$
$$C0 + C1 + C2 + C3 + ...... + Cn = FS$$

Die Größen dUi im Gleichungssystem GS3 sind dimensionslos, da sie sich auf die Full-scale-bzw. die Einheitsspannung beziehen. Mit den bekannten Fehlerspannungen dUi können mit Hilfe der Recheneinheit RE die Kapazitätswerte Ci berechnet werden. Dabei wird die Eigenschaft ausgenutzt, daß der zu kalibrierende A/D-Umsetzer zur Quantisierung der Fehlerspannungen dUi selbst verwendet werden kann. Das Ergebnis des ersten Durchlaufs dieses erfindungsgemäßen Kalibrierungsverfahrens ist aufgrund des relativ ungenauen Umsetzers ebenfalls vergleichsweise ungenau. Nach dem erfindungsgemäßen Verfahren läßt sich jedoch die Genauigkeit eines Umsetzers iterativ verbessern.

Dieses erfindungsgemäße Selbstkalibrierungsverfahren mit iterativer Verbesserung der Genauigkeit wird derart durchgeführt, daß im ersten Durchgang die Fehlerspannungen dUi mit dem noch relativ ungenauen Umsetzer bestimmt, die Kapazitäten Ci ermittelt und die Fehlerspannungen dUi quantisiert werden. Beim nächsten Durchgang des iterativen Verfahrens, einem reinen Berechnungsdurchgang, werden die im ersten Durchgang erhaltenen Ergebnisse verwendet, um die Kapazitäten wiederum genauer bestimmen zu können usw.

Das Selbstkalibrierungsverfahren wird beendet, wenn zwischen den Ergebnissen zweier Durchläufe ein Abweichungskriterium erfüllt ist. Dieses Abweichungskriterium ergibt sich beispielsweise aus der geforderten Genauigkeit des Umsetzers oder der möglichen Berechnungsgenauigkeit für die Elemente unter Berücksichtigung parasitärer Eigenschaften. Vorzugsweise wird als Kriterium jedoch eine feste Zahl an Rechenschleifen, z.b. 10 oder 15 vorgegeben.

Der erfindungsgemäße Selbstkalibrierungsvorgang mit iterativem Verfahren konvergiert in der Praxis und in der Theorie schnell zu einer exakten Lösung, deren Qualität im wesentlichen von den Parametern abhängt, die auch bei aus dem Stand der Technik bekannten Umsetzern die Qualität bestimmen, nämlich z.B. Auflösungsvermögen, Offset und Rauschen. Aufgrund des iterativen Verfahrens ist eine außerordentlich hohe Genauigkeit des Umsetzers zu erreichen, obwohl die Anpassungstoleranzen des Umsetzers einige Prozent betragen dürfen.

Im Gegensatz zu aus dem Stand der Technik bekannten redundanten Umsetzern ergibt sich mit selbstkalibrierenden Umsetzern nach dem erfindungsgemäßen Verfahren kein nachteiliger Zusammenhang zwischen Anpassung der Elemente und dem Aufwand, beispielsweise dem Schaltungsaufwand. Weiterhin ist das erfindungsgemäße Selbstkalibrierungsverfahren uneingeschränkt für redundante gewichtete Netzwerke einsetzbar, obwohl redundante Umsetzer sich vergleichsweise schlecht integrieren lassen. Binäre Umsetzer sind in dieser Hinsicht leichter zu realisieren, da sich bei einer Integration gleiche Strukturen sehr gut herstellen lassen. Aus diesem Grund bedeutet die Selbstkalibirierung für redundante Umsetzer eine wesentliche Verbesserung gegenüber dem gesamten bekannten Stand der Technik.

Der Vorteil des anhand der beiden Ausführungsbeispiele gemäß FIG 2 und FIG 3 geschilderten erfindungsgemäßen Verfahrens liegt darin, daß es sich mit keinen oder mit geringfügigen Einschränkungen für redundante gewichtete Netzwerke eignet und damit für Umsetzer, die nach dem Prinzip der Codeüberlappung arbeiten. Für diese Umsetzer ist das erfindungsgemäße Verfahren darüberhinaus leicht implementierbar. Ein weiterer Vorteil ergibt sich daraus, daß für das erfindungsgemäße Selbstkalibrierungsverfahren nur gegebenenfalls ein eigener Kalibrier-D/A-Umsetzer erforderlich ist. Möglicherweise ergibt sich jedoch ein höherer Rechenaufwand als bei vergleichbaren Selbstkalibrierungsverfahren für binär gewichtete Netzwerke.

Für die bei den beschriebenen Verfahren notwendige Lösung des durch Messung ermittelten Gleichungssystems eignen sich Rechenverfahren, wie sie aus dem Stand der Technik allgemein bekannt sind. So führt das Ausführungsbeispiel gemäß FIG 2 durch Matrixinversion zu einer exakten Lösung. Beim iterativen Verfahren gemäß FIG 3 ist es zweckmäßig, Startwerte für die Berechnung vorzusehen, wobei diese Startwerte vorteilhaft die Idealwerte der gewichteten Elemente darstellen. Je nach Anforderung an die Speichereigenschaften der für die Durchführung des erfindungsgemäßen Verfahrens erforderlichen Speicher wird jeder durchschnittliche Fachmann beispielsweise ein ROM als Startwertspeicher und für die Korrekturwerte bzw. die ermittelten Kapazitätswerte ein RAM oder EEPROM vorsehen.

## Patentansprüche

1. Kalibrierungsverfahren für redundante A/D- und D/A-Umsetzer mit gewichtetem Netzwerk und Fehlerkorrektur, **gekennzeichnet** durch eine Selbstkalibrierung, bei der durch eine Messung mit n Schritten bis auf das niedrigst gewichtete Element jedes von n gewichteten Elemente (C1 bis Cn) als Funktion von jeweils niedriger gewichteten Elementen bestimmt und anschließend jedes gewichtete Element (C0 bis Cn) bezüglich der Summe (FS) aller gewichteten Elemente in Abhängigkeit von den Meßergebnissen ($D_{ij}$) mit Hilfe einer Recheneinheit (RE) berechnet und abgespeichert wird, wobei im einzelnen folgende Schritte vorgesehen sind:
   a) schrittweise werden
      a1) jedes gewichtete Element (C1 bis Cn) bis auf das niedrigstgewichtete Element (C0) des Netzwerks als Summe aller jeweils mit einem digitalen Koeffizienten ($D_{ij}$) multiplizierten niedriger gewichteten Elemente festgestellt und
      a2) die Parameter zwischengespeichert,
   b) die Gewichtung jedes gewichteten Elements (C0 bis Cn) wird mit Hilfe der Recheneinheit (RE) aus den zwischengespeicherten Parametern berechnet,
   c) die Gewichtung jedes gewichteten Elements bezüglich der Gewichtungssumme (FS) aller gewichteten Elemente (C0 bis Cn) des Netzwerks wird gebildet und abgespeichert.

2. Kalibrierungsverfahren für redundante A/D- und D/A-Umsetzer mit gewichtetem Netzwerk und Fehlerkorrektur, **gekennzeichnet** durch eine Selbstkalibrierung, bei der durch eine Messung mit n Schritten bis auf das niedrigst gewichtete Element jedes von n gewichteten Elemente (C1 bis Cn) als Funktion von jeweils niedriger gewichteten Elementen bestimmt und anschließend jedes gewichtete Element (C0 bis Cn) bezüglich der Summe (FS) aller gewichteten Elemente in Abhängigkeit von den Meßergebnissen ( dUi) mit Hilfe einer Recheneinheit (RE) berechnet und abgespeichert wird, wobei im einzelnen iterative Durchläufe mit jeweils folgenden Schritten vorgesehen sind:
   a) schrittweise werden
      a1) eine Fehlerspannung (dUi) oder ein Fehlerstrom bezüglich des Quotienten aus jedem gewichteten Element (C1 bis Cn) - bis auf das niedrigstgewichtete Element (C0) - des Netzwerks und der Gewichtungssumme aller jeweils niedriger gewichteten Elemente festgestellt und
      a2) die Parameter zwischengespeichert,
   b) die Gewichtung jedes gewichteten Elements (C0 bis Cn) wird mit Hilfe der Recheneinheit aus den zwischengespeicherten Parametern berechnet und das Ergebnis zwischengespeichert,
   c) die zwischengespeicherten Ergebnisse werden elementweise mit den gegebenenfalls im vorangegangenen Durchlauf zwischengespeicherten Ergebnissen der berechneten Gewichtungen verglichen,
   d) bei der Erfüllung eines Kriteriums werden die berechneten Gewichtungen der gewichteten Elemente

EP 0 320 642 B1

(C0 bis Cn) zwischengespeichert und

e) die Gewichtung jedes gewichteten Elements bezüglich der Gewichtssumme aller gewichteten Elemente (C0 bis Cn) des Netzwerks wird gebildet, abgespeichert und das Kalibrierungsverfahren beendet,

f) mit den im Schritt b) berechneten und zwischengespeicherten Gewichtungen wird die Berechnung der gewichteten Elemente nach Schritt b) wiederholt.

3. Verfahren nach Anspruch 2,
**dadurch gekennzeichnet**, daß die Fehlerspannungen bzw. Fehlerströme mit dem zu kalibrierenden Umsetzer selbst festgestellt und quantisiert werden.

4. Verfahren nach Anspruch 2 oder 3,
**dadurch gekennzeichnet**, daß als Kriterium eine feste Anzahl von Durchläufen vorgegeben wird.

5. Verfahren nach Anspruch 2 oder 3,
**dadurch gekennzeichnet**, daß als Kriterium ein Abweichungswert zwischen Ergebnissen zweier Durchläufe vorgegeben wird.

6. Verfahren nach Anspruch 2 bis 5
**dadurch gekennzeichnet**, daß beim ersten Kalibrierungsdurchlauf Gewichtungsstartwerte für jedes gewichtete Element (C0 bis Cn) einem Festwertspeicher entnommen werden.

7. Verfahren nach Anspruch 1 bis 6,
**dadurch gekenzeichnet**, daß die berechnete Gewichtung jedes gewichteten Elements (C0 bis Cn) als Wort mit Redundanz-Bitbreite abgespeichert wird.

## Claims

1. Calibration process for redundant A/D and D/A converters with a weighted network and error correction, characterized by a self-calibration, in which by a measurement with n steps, apart from the lowest-weighted element, each one of weighted elements (C1 to Cn) is determined as a function of in each instance lower-weighted elements and subsequently each weighted element (C0 to Cn) is computed with respect to the total (FS) of all weighted elements as a function of the measurement results ($D_{ij}$) with the aid of a computer unit (RE) and stored, in detail the following steps being provided:
    a) stepwise
       a1) each weighted element (C1 to Cn) apart from the lowest-weighted element (C0) of the network is established as the total of all lower-weighted elements multiplied in each instance by a digital coefficient ($D_{ij}$) and
       a2) the parameters are placed in intermediate storage,
    b) the weighting of each weighted element (C0 to Cn) is computed with the aid of the computer unit (RE) from the parameters placed in intermediate storage,
    c) the weighting of each weighted element with respect to the total weighting (FS) of all weighted elements (C0 to Cn) of the network is formed and stored.

2. Calibration process for redundant A/D and D/A converters with a weighted network and error correction, characterized by a self-calibration, in which by a measurement with n steps, apart from the lower-weighted element, each one of n weighted elements (C1 to Cn) is determined as a function of in each instance lower-weighted elements and subsequently each weighted element (C0 to Cn) is computed with respect to the total (FS) of all weighted olements as a function of the measurement results (dUi) with the aid of a computer unit (RE) and stored, in detail iterative runs with in each instance the following steps being provided:
    a) stepwise
       a1) an error voltage (dUi) or an error current is established with respect to the quotient of each weighted element (C1 to Cn) - apart from the lowest-weighted element (CO) - of the network and the total weighting of all in each instance lower-weighted elements and
       a2) the parameters are placed in intermediate storage,
    b) the weighting of each weighted element (C0 to Cn) is computed with the aid of the computer unit from the parameters placed in intermediate storage and the result is placed in intermediate storage,
    c) the results placed in intermediate storage are compared element by element with the results - pos-

7

sibly placed in intermediate storage in the preceding run - of the computed weightings,

d) in the event of the fulfilment of a criterion, the computed weightings of the weighted elements (C0 to Cn) are placed in intermediate storage and

e) the weighting of each weighted element with respect to the total weighting of all weighted elements (C0 to Cn) of the network is formed, stored and the calibration process is ended,

f) using the weightings computed and placed in intermediate storage in the step b), the computation of the weighted elements according to step b) is repeated.

3. Process according to Claim 2, characterized in that the error voltages or error currents are established by the converter to be calibrated itself and quantized.

4. Process according to Claim 2 or 3, characterized in that a fixed number of runs is prescribed as criterion.

5. Process according to Claim 2 or 3, characterized in that a deviation value between results of two runs is prescribed as criterion.

6. Process according to Claims 2 to 5, characterized in that in the first calibration run initial weighting values for each weighted element (C0 to Cn) are taken from a read-only memory.

7. Process according to Claims 1 to 6, characterized in that the computed weighting of each weighted element (C0 to Cn) is stored as a word with a redundancy bit width.

**Revendications**

1. Procédé de calibrage pour des convertisseurs analogique/numérique et numérique/analogique redondants comportant un réseau pondéré et une unité de correction d'erreurs, caractérisé par un équilibrage automatique, lors duquel, au moyen d'une mesure sur n pas, chacun de n éléments pondérés (C1 à Cn) est déterminé, hormis l'élément possédant la pondération la plus faible, en fonction d'éléments pondérés respectivement avec une pondération plus faible et ensuite, chaque élément pondéré (C0 à Cn) est calculé en rapport avec la somme (FS) de tous les éléments pondérés, au moyen d'une unité de calcul (RE), en fonction des résultats de mesure ($D_{ij}$) et est mémorisé, auquel cas, on prévoit de façon détaillée les étapes opératoires suivantes :

a) pas-à-pas

a1) on détermine chaque élément pondéré (C1 à Cn), hormis l'élément (CO) du réseau qui possède la pondération la plus faible, sous la forme d'une somme de tous les éléments pondérés avec une pondération plus faible, multipliés chacun par un coefficient numérique ($D_{ij}$), et

a2) on mémorise temporairement les paramètres,

b) la pondération de chaque élément pondéré (C0 à Cn) est calculée à l'aide de l'unité de calcul (R1) à partir des paramètres mémorisés temporairement,

c) la pondération de chaque élément pondéré est réalisée, par rapport à la somme de pondération (FS) de tous les éléments pondérés (C0 à Cn) du réseau, et est mémorisée.

2. Procédé de calibrage pour des convertisseurs analogique/numérique et numérique/analogique redondants comportant un réseau pondéré et une unité de correction d'erreurs, caractérisé par un équilibrage automatique, lors duquel, au moyen d'une mesure sur n pas, chacun de n éléments pondérés (C1 à Cn) est déterminé, hormis l'élément possédant la pondération la plus faible, en fonction d'éléments pondérés respectivement avec une pondération plus faible et ensuite, chaque élément pondéré (C0 à Cn) est calculé en rapport avec la somme (FS) de tous les éléments pondérés, au moyen d'une unité de calcul (RE), en fonction des résultats de mesure (dVi) et est mémorisé, auquel cas, on prévoit de façon détaillée les étapes opératoires suivantes :

a) pas-à-pas

a1) on détermine une tension de défaut (dUi) ou un courant de défaut en rapport avec le quotient entre chaque élément pondéré (C1 à Cn) - hormis l'élément (CO) pondéré avec la pondération la plus faible - du réseau, et la somme de pondération de tous les éléments pondérés avec une pondération respectivement plus faible, et

a2) on mémorise temporairement les paramètres,

b) la pondération de chaque élément pondéré (C0 à Cn) est calculée à l'aide de l'unité de calcul à partir des paramètres mémorisés temporairement, et le résultat est mémorisé temporairement,

c) les résultats mémorisés temporairement sont comparés, élément par élément, aux résultats, éventuellement mémorisés temporairement lors du cycle précédent, des pondérations calculées,
d) lorsqu'un critère est satisfait, les pondérations calculées des éléments pondérés (C0 à Cn) sont mémorisées temporairement, et
e) la pondération de chaque élément pondéré est formée, en rapport avec la somme des poids de tous les éléments pondérés (C0 à Cn) du réseau, et est mémorisée et la procédure de calibrage est arrêtée,
f) le calcul des éléments pondérés conformément l'étape b) est répété avec les pondérations calculées lors de l'étape b) et mémorisées temporairement.

3. Procédé suivant la revendication 2, caractérisé par le fait que les tensions de défaut ou les courants de défaut sont déterminées et quantifiées au moyen du convertisseur devant être calibré, lui-même.

4. Procédé suivant la revendication 2 ou 3, caractérisé par le fait qu'un nombre fixe de cycles est prédéterminé comme critère.

5. Procédé suivant la revendication 2 ou 3, caractérisé par le fait qu'une valeur d'écart entre les résultats de deux cycles est prédéterminée en tant que critère.

6. Procédé suivant les revendications 2 à 5, caractérisé par le fait que lors du premier cycle de calibrage, des valeurs de départ de pondération pour chaque élément pondéré (C0 à Cn) sont prélevées d'une mémoire de valeurs fixes.

7. Procédé suivant les revendications 1 à 6, caractérisé par le fait que la pondération calculée de chaque élément pondéré (C0 à Cn) est mémorisée sous la forme d'un mot possédant une largeur en bits de redondance.

# FIG 1

# FIG 2

# FIG 3